# EUROPEAN PATENT APPLICATION

(11) **EP 1 189 265 A1**
(43) Date of publication of application: **20.03.2002**
(21) Application number: 01912262.1
(22) Date of filing: 12.03.2001
(51) Int. Cl.: H01L 21/304

(54) **WATER FOR STORING SILICON WAFERS AND STORING METHOD**

(30) Priority: 17.03.2000 JP 2000076490; 17.05.2000 JP 2000145444
(71) Applicant: Shin-Etsu Handotai Co., Ltd, Tokyo 100-0005 (JP)
(72) Inventor: ABE, Tatsuo, c/o SHIN-ETSU HANDOTAI CO., LTD., Nishishirakawa-gun, Fukushima 961-8061 (JP)
(74) Representative: Grünecker, Kinkeldey, Stockmair & Schwanhäusser Anwaltssozietät
(86) International application number: JP0101903
(87) International publication number: WO0171788

(57) **Abstract**

The present invention provides storage water for storing a silicon wafer which is capable of decreasing attachment of fine particles including metals on a wafer surface, preventing a wafer surface from being etched by an alkaline component of a polishing agent, and preventing deterioration in wafer quality, especially in gate oxide integrity after cleaning, or preventing deterioration in haze and attachment of particles, and provides a method for storing a silicon wafer. The storage water for storing a silicon wafer comprises pure water and an organic acid having a chelating effect, which storage water is in the state ranging from being weakly acid to neutral, or comprises pure water and a nonionic surfactant.

## Description

### Technical Field:

The present invention relates to storage water used in storing a silicon wafer (hereinafter simply referred to also as a "wafer"), particularly a wafer directly after etching or polishing, and a method for storing a silicon wafer.

### Background Art:

A manufacturing process for a silicon wafer generally includes the following steps: a slicing step for slicing a single crystal ingot to obtain a wafer in the shape of a thin disc, a chamfering step for chamfering a peripheral portion of the wafer obtained in the slicing step in order to prevent breakage and chipping thereof, a lapping step for planarizing the chamfered wafer, an etching step for removing work damages remaining in the chamfered and lapped wafer, a polishing step for mirror-finishing a surface of the etched wafer and a cleaning step for cleaning the polished wafer to remove a polishing agent and dust particles attached thereon.

The above process shows only main steps of the manufacturing process for the silicon wafer, and other steps such as a heat treatment step and so on may be added thereto, and/or the order of the steps may be changeable. There are some cases where temporary storage of the wafer is required between the steps before being transferring to the next step. Such temporary storage is necessarily conducted according to a method suited for a state of the silicon wafer.

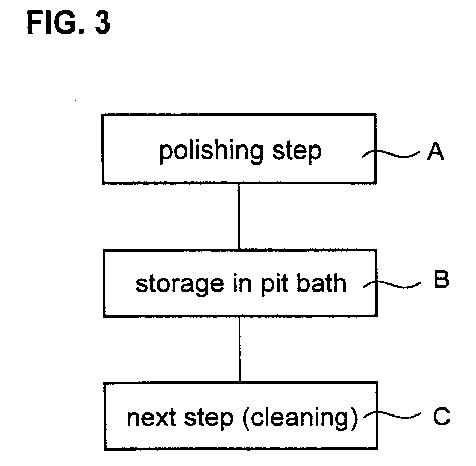

For example, as shown in Fig. 3, a wafer after a polishing step A is subsequently treated in a cleaning step C. The wafer is usually stored in water (pure water) during a waiting time before being transferred to the cleaning step C (storage in pit bath B). This is because if the wafer is left in the atmospheric air, polishing slurry is desiccated to be adhered to the wafer surface and the adhered slurry is hard to be removed in the next cleaning step.

In addition to this, a wafer surface after being polished is very unstable. For this reason, there arise problems that during the storage of the wafer fine particles including metal are easy to attach onto the wafer surface and furthermore, the wafer surface is easily etched by an action of an alkaline component in the polishing slurry. These problems are large factors lowering a wafer quality after the cleaning, especially deteriorating gate oxide integrity.

For the purpose of preventing a decrease in gate oxide integrity caused by metal contamination, the applicant of this application developed and proposed a technique in which a concentration of metals, especially Cu in storage water is defined (JP A 99-191543), and a technique in which a chelating agent is added to storage water (JP A 99-243073). In these techniques, however, poor gate oxide integrity is improved, but there have arisen the following problems: The technique described in JP A 99-191543 requires checking constantly that a Cu concentration is equal to or less than 0.01 ppt, and the technique described in JP A 99-243073 in which a chelating agent such as EDTA (ethylenediaminetetraacetic acid) is added, leads to concerns with treatment of wastewater, and the fact that a wafer surface is roughened by an etching action of an alkaline component (for example, aqueous ammonia) for dissolving the chelating agent.

Furthermore, there has been used a process in which an oxide film is formed on a wafer surface with hydrogen peroxide or ozone in order to prevent attachment of fine particles (JP A 95-263403, JP A 96-83783 and others).

However, a wafer on which an oxide film is formed can prevent attachment of particles, but causes a problem of roughening of a wafer surface.

Thus, no conventional storage water for storing a silicon wafer can sufficiently function for preventing surface roughness (deterioration in haze) and particle attachment.

### Disclosure of the Invention:

The present invention has been made in light of the above problems and it is an object of the present invention to provide storage water for storing a silicon wafer which is capable of decreasing attachment of fine particles including metals on a wafer surface, preventing a wafer surface from being etched by an alkaline component of a polishing agent, and preventing deterioration in wafer quality, especially in GOI (Gate Oxide Integrity) after cleaning, or preventing deterioration in haze and attachment of particles, and to provide a method for storing a silicon wafer.

In order to solve the above problems, according to a first aspect of storage water of the present invention, there is provided storage wafer for storing a silicon wafer in water which comprises pure water and an organic acid having a chelating effect, which storage water is in the state ranging from being weakly acid to neutral.

As the organic acid, there can be preferably exemplified as follows: a water-soluble organic acid having ten or less carbon atoms and two or more carboxyl groups such as oxalic acid, citric acid, tartaric acid, malic acid, malonic acid or benzenetetracarboxylic acid. Citric acid is especially preferable among them.

It is also possible that the above storage water further contains a surfactant.

A pH value of the storage water preferably ranges from 3 to 7, and more preferably from 4 to 7.

An additive amount of the organic acid is preferably in the concentration range of from 0.0001 to 0.01 % and more preferably from 0.0001 to 0.005 %. Note that when an additive amount or a concentration of the organic acid is indicated simply by %, it means wt %.

In a polishing step, there is generally used an alkaline polishing agent containing an alkaline component. In many cases, wafers are stored in storage water directly after polishing. In such cases, when wafers are stored in the storage water of an acid solution containing an organic acid having a chelating effect, for example, citric acid or citric acid and a surfactant, the storage water can effectively neutralize the alkaline component attached on the wafer surface and hence, the excessive etching by the alkaline component is prevented, thereby a surface state of the wafer surface being kept good.

Accordingly, while the storage water after polishing gradually changes to alkalinity with increase in the number of times of use, a change to alkalinity is prevented if the wafers are stored in a solution containing an organic acid having a chelating effect, for example, citric acid or citric acid and a surfactant, which solution ranges from being acid to neutral. It is not preferable that the storage water for storing a silicon wafer has an etching effect to the silicon wafer. This is because a problem arises that since a storage time is not constant, the presence of an etching effect of the storage water results in different surface state of the stored wafers according to batches together with other inconveniences. In order to decrease an etching effect, the storage water is constituted of pure water as a base component and an organic acid having a chelating effect, for example, citric acid as a additive component. If necessary, a surfactant or the like is further added thereto.

A second aspect of storage water for storing a silicon wafer of the present invention comprises pure water and a nonionic surfactant.

By immersing a wafer in the storage water prepared by adding such a nonionic surfactant, the wafer can be stored in the same surface state (without generating a roughened surface) for a long time (regardless of an elapsed time).

The surface directly after polishing is in a state that silicon is in a bare state. On the other hand, the storage water contains dissolved oxygen and the dissolved oxygen reacts with the silicon on the surface to form a thin oxide film thereon. The oxide film is, however, considered to produce a roughed surface by dissolving into the storage water.

Consequently, it is a main feature of the present invention to add a surfactant to storage water in order that no oxide film is formed on a silicon surface, or alternatively, the oxide film, even if formed, is not dissolved into the storage water, thereby protecting the wafer surface. A concentration of the surfactant in the storage water of the present invention is preferably equal to or more than 0.01 %. Note that in this specification, when an additive amount or a concentration of a surfactant is indicated simply by %, it means vol %.

When a surface of a wafer is treated with hydrogen peroxide or ozone to form an oxide film, a similar roughened surface of the wafer is produced. There have been exerted an effect of preventing production of a roughened surface of a wafer by adding a surfactant to storage water even containing such a material as hydrogen peroxide or ozone.

If a surfactant is added into storage water, molecules of the surfactant are physically adsorbed onto a silicon wafer to protect a surface thereof. As a surfactant to be added for protecting a surface of a wafer, there is preferably used one that is dispersed uniformly all over the surface of a wafer, prevents attachment of external contaminants to the surface of a wafer, and has no contaminant in itself.

The following surfactants are used: nonionic surfactants such as polyoxyalkylenealkyl ether, for example polyoxyethylenealkyl ether, polyoxyethylene polyoxypropylene ether, sorbitan aliphatic acid ester, polyoxyethylene sorbitan aliphatic acid ester, polyoxyethylene sorbitol aliphatic acid ester, glycerol aliphatic acid ester, polyoxyethylenealiphatic acid ester, polyoxyethylenealkylamine, polyoxyethylene glyceride and alkylalkanol amide.

Especially, polyoxyalkylenealkyl ether such as polyoxyethylenealkyl ether, and/or polyoxyethylene polyoxypropyene ether may be preferably used because these compounds do not contain metallic impurities which reduce GOI, so high purity surfactants can be produced therefrom.

Furthermore, it is preferable that a pH value of the storage water is adjusted so as not to be in the alkaline side. That is, the pH value is preferably equal to or less than 7. Although the storage water has a capability of preventing a wafer surface from being roughened when a pH value is even in the alkaline side, sufficient improvement cannot be achieved and the wafer surface deteriorates in quality; therefore, a wafer is preferably stored in the storage water ranging from being neutral to acid. From this viewpoint, a cationic surfactant is preferable to an anionic surfactant and a nonionic surfactant is much preferable thereto in preventing deterioration in surface roughness. There is available an undiluted solution of a nonionic surfactant having a pH value of a little less than 4, for example, a higher alcohol nonionic surfactant such as polyoxyalkylenealkyl ether. When such a surfactant is added, a pH value of the storage water can be controlled on the order of 4 to 7. Wafers are preferably stored in the storage water in the pH range with no deterioration in quality. While the use of a cationic surfactant can also meet the above pH range, there is a problem that no cationic surfactant of a higher purity degree to which it can be added to the storage water can be currently obtained with ease. A cationic surfactant of high purity can exert an effect equivalent to a nonionic surfactant.

Where a dissolved oxygen concentration is equal to or higher than 3 mg/L in the storage water of the present invention, a greater effect is recognized. A wafer surface directly after polishing is easy to be oxidized under an influence of dissolved oxygen in the storage water (pure water). Since a roughened surface is apt to be produced by oxidation of the wafer, it is important to avoid occurrence of the oxidation reaction to the possible lowest level. Therefore, a measure is necessary for reducing dissolved oxygen in the pure water as low as possible. When a surfactant is added into the pure water or the wafer is stored in the pure water in a state of the wafer surface coated with the surfactant in advance, the wafer may be stored in the storage water without paying attention to the influence of dissolved oxygen. By adding a surfactant, a sufficient effect can be exerted even on occasions when a dissolved oxygen concentration is relatively high of 3 mg/L or more, thereby surface roughening and attachment of particles being prevented. While no specific upper limitation is imposed on a dissolved oxygen concentration, the effect of the present invention can be obtained up to the dissolved oxygen saturation concentration at a working temperature of the storage water. The storage water of the present invention can sufficiently exert the intended function thereof even in combination of a surfactant and pure water only.

According to a first aspect of a method for storing a silicon wafer of the present invention, there is provide a method wherein a wafer is stored in the above storage water of the present invention.

In the first aspect of a method of the present invention, a surfactant is directly added into the storage water. Besides the first aspect, a second aspect of a method of the present invention comprises the steps of: coating a surface of the silicon wafer with a nonionic surfactant; and storing the silicon wafer coated with the surfactant in pure water. In the storing step, it is also effective to store the wafer in storage water prepared by adding an organic acid having a chelating effect such as citric acid into pure water.

In this way, using a surfactant to a wafer independently from storage water to be used actually, the wafer surface can be surely protected and thereby prevented from deterioration. This step is usually performed directly after an etching step and/or a polishing step.

Furthermore, in order to perfectly prevent surface roughening and attachment of particles on a surface of a wafer, it is desirable to protect the wafer surface uniformly in such ways as to add a surfactant in the concentration range of from 0.01 % to 0.1 %, or to once immerse the wafer in a surfactant solution of the order of the concentration range of 10 % to 30 % and thereafter, put the wafer into the storage water. While the effect of a surfactant in the storage water does not change with increase in a concentration thereof, with an excessively low concentration of the surfactant a protective film of the surfactant which cover all of the wafer surface is not perfectly formed, so a concentration of the surfactant in the storage water is preferably equal to or more than 0.01 %. To be more detailed, a concentration of the surfactant is enough to be equal to or more than the critical micelle concentration. Wastewater containing a surfactant cannot be drained directly to the outer environment, special treatment thereof being required. The difficulty in this treatment increases with a higher concentration of the surfactant. Therefore, it is not preferable in an operational aspect to use a surfactant in a concentration higher than necessary; it is preferable that the treatment is performed on the order of in the above concentration range. Furthermore, it is preferable that the storage water is used in a mode of stored water from the viewpoint of decrease in amounts of pure wafer to be used and drainage thereof, and concentration control of the surfactant.

### Brief Description of the Drawings:

FIG. 1 is a flow chart showing a first aspect of a method for storing a silicon wafer of the present invention;
FIG. 2 is a flow chart showing a second aspect of a method for storing a silicon wafer of the present invention; and
FIG. 3 is a flow chart showing a conventional method for storing a silicon wafer.

### Best Mode for Carrying Out the Invention:

Description will be given of embodiments of the present invention below.

Citric acid, which is preferably used as an organic acid having a chelating effect in a first aspect of storage water of the present invention, has a chelating characteristic and a zeta potential characteristic. Citric acid forms a compound with metals in the storage water by the chelating characteristic. Furthermore, there arises a repulsion force between a wafer surface and particles containing metals (silicon dusts, silicic acid particles used in a polishing agent, particles in the liquid and others) by the zeta potential characteristic, thereby attachment of the metals in the storage water to the wafer surface being prevented.

As other examples of an organic acid having a chelating effect, there can be used an organic acid with analogous characteristics to citric acid, for example, an organic acid such as oxalic acid which is water soluble at ordinary temperatures and has carboxyl groups not apart excessively from each other.

As the storage water, it is important to select a concentration range in which cleaning and etching effects are in a low level and, for example, in the case of citric acid, a concentration range is preferably on the order of from 0.0001 to 0.01 % and more preferably on the order of from 0.0001 to 0.005 %. When a concentration of citric acid is less than 0.0001 %, a chelating effect becomes weak and a preventive effect against metal contamination is reduced. On the contrary, as a concentration of citric acid increases, a cost for a chemical fluid and a load of a wastewater treatment increase; therefore, it is necessary for the concentration not to be in excess of 0.01 %. While the waste treatment associated with citric acid is easier compared with a chelating agent, the cost for citric acid cannot be neglected at an excessively high concentration thereof.

In the storage water, it is important to select a pH range where cleaning and etching effects are in a low level and, for example, the pH value is preferably about 3 to 7 and more preferably about 4 to 7.

As a surfactant used in a second aspect of storage water of the present invention, a nonionic surfactant is especially preferable. As nonionic surfactants, there can be used those listed up above and especially preferable among them are ether type nonionic surfactants such as polyoxyalkylenealkyl ether, for example, polyoxyethylenealkyl ether, and polyoxyethylene polyoxypropylene ether. An additive amount of the surfactant is preferably in the range of from 0.01 % to 0.1 % and a pH value of the storage water after addition of the surfactant is preferably equal to or less than 7. Furthermore, a greater effect can be recognized in a dissolved oxygen concentration in the storage water equal to or more than 3 mg/L.

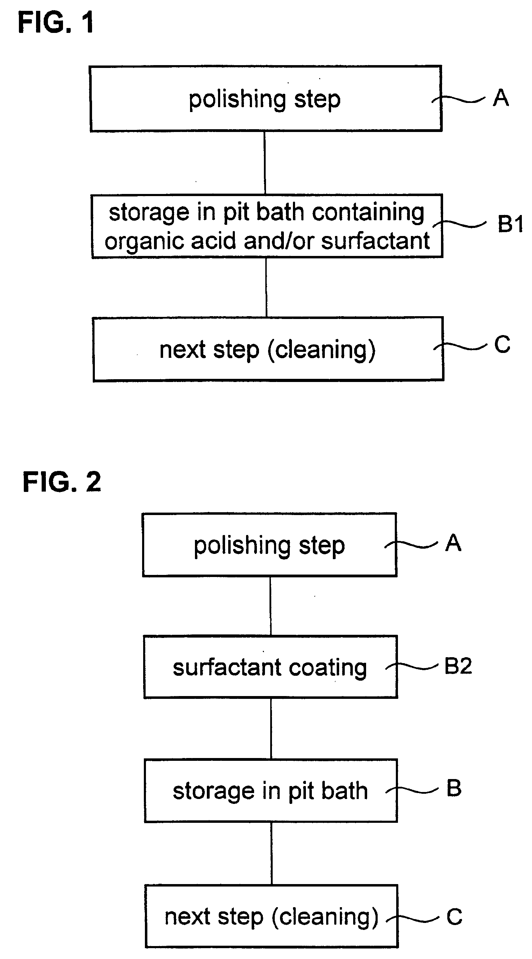

Description will be given of embodiments of a method of the present invention below based on FIGs. 1 and 2. It is needless to say that various modifications or variations can be performed in addition to examples shown in the figures as far as not departing from the technical concept of the present invention.

FIG. 1 is a flow chart showing the first aspect of a method for storing a silicon wafer of the present invention. In FIG. 1, a polishing step A and a next step (cleaning) C are similar to the conventional steps. Storage in pit bath B1 in FIG. 1 is different from the conventional step in that an organic acid having a chelating effect and/or a surfactant is added into storage water (pure water) filling a pit bath.

FIG. 2 is a flow chart showing a second aspect of a method for storing a silicon wafer of the present invention. In FIG. 2, a polishing step A and a next step (cleaning) C are similar to the corresponding steps of FIG. 1 and the conventional steps. A process of FIG. 2 is different from the process of FIG. 1 and the conventional step in that a surface of a silicon wafer is coated with a surfactant prior to the storage in pit bath B. As a surfactant to coat the wafer, the nonionic surfactants can be used in a similar way. While no specific limitation is imposed on a concentration of the surfactant for the coating, it is preferably equal to or more than 10 %. When the concentration is on the order of 10 %, the surfactant can be coated on the wafer surface in a proper thickness. While as in the conventional step, in the storage in pit bath B after the surfactant coating B2, the storage water constituted of 100 % pure water may be sufficiently used, it is also effective to store the wafer in the storage water prepared by adding an organic acid having a chelating effect such as citric acid into pure water.

Concrete description will be further given of the present invention taking up examples. It is needless to say that the examples are shown by way of illustration only and are not to be construed by way of limitation.

### (Examples 1 to 4 and Comparative Example 1)

### Experimental Conditions

Specimen wafer: Silicon wafer, p-type, crystal orientation of < 100 >, 200 mm φ in diameter
Storage bath size: 320 x 600 x 280 (mm)
Polishing process: With a polishing pad made of polyurethane foam, a polishing agent made of colloidal silica and under polishing conditions of a polishing load of 250 g/cm² and a polishing time of 10 min., the final finish polishing was performed.
Storage water: various kinds of storage water each of 50 liters
Example 1: Storage water was prepared by adding a 10 wt % citric acid solution (SC grade; for the electronic industry) into pure water at a citric acid concentration of 0.005 wt % (at this time, pH = 4.1).
Example 2: Storage water was prepared by adding a 10 wt % citric acid solution (SC grade; for the electronic industry) into pure water at a citric acid concentration of 0.005 wt % and further adding a surfactant (NCW601A, a nonionic surfactant made by Wako Pure Chemical Industries, Ltd.) at 0.01 wt % thereinto (at this time, pH = 3.8).
Example 3: Storage water was prepared by adding a 10wt % citric acid solution (SC grade; for the electronic industry) into pure water at a citric acid concentration of 0.05 wt % (at this time, pH = 3.3).
Example 4: Storage water was prepared by adding a 10wt % citric acid solution (SC grade; for the electronic industry) into pure water at a citric acid concentration of 0.0005 wt % (at this time, pH = 5.1).
Comparative Example 1: Storage water constituted of pure water only (at this time, pH = 6.2).

Twenty pieces of the above specimen wafers after polishing were stored in the storage water of various kinds described above. Storage times of the specimen wafers in the storage water were set in 2, 4, 8 and 12 hours. The specimen wafers after storing in the storage water were cleaned using an SC-1 cleaning liquid (the liquid temperature of 80°C) constituted of a mixture of aqueous ammonia, a hydrogen peroxide aqueous solution and pure water with a ratio of 1 : 1 : 10 for 5 min. and further cleaned using an SC-2 liquid (the liquid temperature of 80°C) constituted of a mixture of hydrochloric acid, a hydrogen peroxide aqueous solution and pure water with a ratio of 1 : 1 : 20 for 5 min., followed by quality evaluation.

The quality evaluation was performed in terms of GOI (Gate Oxide Integrity). The GOI evaluation is one of the most important parameters for evaluation of a wafer quality (reliability of an insulating film). GOI is one of methods capable of evaluating a metal contamination amount in a wafer. A result of GOI evaluation depends on a metal contamination amount and a distribution thereof; therefore, the result can be the basis for examining a wafer to see whether it is good or bad.

MOS capacitors each with a gate oxide film, i.e., an insulating film of 25 nm thick were formed on each of wafers of the Examples and Comparative Example and evaluation on GOI of the wafers was performed.

The GOI evaluation was performed according to two methods: one in which the MOS capacitor is applied with an electric field in a step-wise fashion to measure dielectric breakdown electric field strength of the MOS capacitor [an electric field breakdown distribution: TZDB (Time Zero Dielectric Breakdown) method] and the other in which an electric field with a given strength is applied on the MOS capacitor and proportions in number of the MOS capacitors dielectrically broken down in time intervals over an elapsed time are measured while changing strength of the electric field [a time-dependent breakdown distribution TDDB (Time Dependent Dielectric Breakdown) method].

Results of the TZDB method are expressed in three modes: A mode in which dielectric breakdown occurs due to an early stage short circuit, B mode in which dielectric breakdown occurs at an electric field ranging from 1 MV/cm to 8 MV/cm, and C mode (good chip) in which a current density in decision is reached with no dielectric breakdown (in this mode, dielectric breakdown strength is equal to or higher than 8 MV/cm). In the Examples and Comparative Example, the current density in decision was 1 mA per gate area of 8 mm².

Results of the TDDB method are likewise expressed in different three modes: α mode (bad chip) in which dielectric breakdown instantly occurs, β mode (quasi-good chip) in which dielectric breakdown occurs at an electric field equal to or lower than 5C/cm² and γ mode (good chip) in which no dielectric breakdown is produced (dielectric breakdown occurs at an electric field equal to or higher than 5C/cm²). In the Examples and Comparative Example, the TDDB method was applied in conditions of a stress current value of 0.01 A/cm², a measuring temperature of 100°C and a gate area of 4 mm².

Evaluation results on GOI are shown in Tables 1 and 2. While, in case of pure water only, a good chip mode (γ mode) in TDDB was worsened with elapse of time, in cases where citric acid was added to pure water or citric acid and a surfactant combined are added thereto, a good chip yield was high.

From the above results, it has been found that the storage water containing an organic acid having a chelating effect, for example, citric acid or citric acid + a surfactant, is especially preferable in terms of a wafer surface quality, especially gate oxide integrity.

**Table 1**

| | | Example 1 | Example 2 | Example 3 | Example 4 |
|---|---|---|---|---|---|
| After 2 hrs. storage storage | TZDB C-mode (%) | 69.7 | 68.0 | 70.25 | 74.0 |
| | TDDB α (%) | 25.2 | 20.5 | 17.5 | 17.5 |
| | β (%) | 2.5 | 1.0 | 2.25 | 2.25 |
| | γ (%) | 72.2 | 78.5 | 80.25 | 80.25 |
| After 4 hrs. storage | TZDB C-mode (%) | 64.5 | 68.7 | 72.75 | 72.5 |
| | TDDB α (%) | 27.5 | 22.2 | 17.25 | 17.25 |
| | β (%) | 1.0 | 0.7 | 1.5 | 3.25 |
| | γ (%) | 71.5 | 77.0 | 81.25 | 79.5 |
| After 8 hrs. storage | TZDB C-mode (%) | 70.7 | 68.5 | 77.25 | 73.5 |
| | TDDB α (%) | 22.2 | 20.0 | 21.25 | 15.5 |
| | β (%) | 1.7 | 3.0 | 1.25 | 2.0 |
| | γ (%) | 76.0 | 77.0 | 77.5 | 82.5 |
| After 12 hrs. storage | TZDB C-mode (%) | 70.0 | 70.0 | 70.0 | 68.0 |
| | TDDB α (%) | 17.5 | 17.0 | 18.25 | 20.25 |
| | β (%) | 0.7 | 1.0 | 2.0 | 2.75 |
| | γ (%) | 81.7 | 77.0 | 79.75 | 77.0 |

**Table 2**

| | | Comparative Example 1 |
|---|---|---|
| After 2 hrs. storage | TZDB C-mode (%) | 70.0 |
| | TDDB α (%) | 28.5 |
| | β (%) | 1.7 |
| | γ (%) | 69.5 |
| After 4 hrs. storage | TZDB C-mode (%) | 65.0 |
| | TDDB α (%) | 28.0 |
| | β (%) | 13.0 |
| | y (%) | 59.0 |
| After 8 hrs. storage | TZDB C-mode (%) | 72.2 |
| | TDDB α (%) | 21.2 |
| | β (%) | 58.2 |
| | γ (%) | 20.5 |
| After 12 hrs. storage | TZDB C-mode (%) | 68.0 |
| | TDDB α (%) | 41.2 |
| | β (%) | 54.5 |
| | γ (%) | 4.2 |

### (Examples 5 and 6 and Comparative Example 2)

Storage water and the like are sometimes mixed with metals under some influence or others. In such cases, an influence of metal contamination is apt to occur. Accordingly, in order to confirm the effect of the storage water in a severe environment, experiments were performed in which metal contamination (Cu) of the order of 1000 ppt in concentration was intentionally given into storage water similar to that used in Examples 1 and 2 and Comparative Example 1, and wafers were stored in the contaminated storage water for 12 hours, followed by evaluation on gate oxide integrity. Evaluation results thereof are shown in Table 3. In Examples 5 and 6 and Comparative Example 2, there was used storage water similar to those of Examples 1 and 2 and Comparative Example 1, respectively. Note that specifications of wafers used in these experiments were similar to those of Examples 1 to 4 and Comparative Example 1 and polishing conditions and treatment conditions before and after storage were also similar to those of Examples 1 to 4 and Comparative Example 1.

**Table 3**

| | | Example 5 | Example 6 | Comparative Example 2 |
|---|---|---|---|---|
| After 12 hrs. storage | TZDB C-mode (%) | 66.0 | 69.0 | 0.0 |
| | TDDB α (%) | 27.0 | 18.0 | 100.0 |
| | β (%) | 12.0 | 1.0 | 0.0 |
| | γ (%) | 61.0 | 81.0 | 0.0 |

In cases where Cu contamination existed, a good chip yield was greatly lowered with only pure water or with only addition of a surfactant to pure water. In contrast, reduction in a yield in good chip was prevented in Examples 5 and 6. Reduction in yield in good chip can be further prevented by combination of citric acid and a surfactant.

In terms of metal contamination, an effect of citric acid was confirmed even with an additive amount of the order of 1 %, but this additive amount was excessive; the amount was preferably 0.0001 to 0.01 %, especially preferably 0.0001 to 0.005 % from the viewpoint of surface quality of a wafer.

Note that when many wafers were stored in the storage water, an alkaline component used in polishing came into the storage water and as a result, pH of the storage water gradually shifted toward the alkaline side. Because of this alkaline effect, surface quality of a wafer after the storage was sometimes deteriorated. An alkaline component used in polishing is a cause of a problem and it is preferable to store a wafer in storage water with pH equal to or less than 7.

### (Examples 7 and 8 and Comparative Examples 3 and 4)

In order to confirm an influence of an alkaline component, evaluation on microroughness of a wafer surface was performed. The Examples and Comparative Example were performed using the following storage water prepared in four ways: storage water of a citric acid concentration 0.005 wt %, which is similar to that of Example 1, at pH = 4.1 (Example 7); storage water of a citric acid concentration 0.005 wt %, further added with a surfactant, which is similar to that of Example 2, at pH = 3.8 (Example 8); storage water in which EDTA is dissolved in aqueous ammonia at a concentration of 0.5 mol/l at pH = 9.0 (Comparative Example 3); and storage water of an ammonia concentration of 0.005 wt % at pH = 9.6 (Comparative Example 4).

Mirror polished wafers were stored in various kinds of storage water for 12 hours and thereafter, a difference in microroughness of each wafer between before and after the storage was evaluated to thereby confirm deterioration in a surface state. The microroughness on each wafer surface was evaluated with LS-6000 made by Hitachi Electronics Engineering Co. Ltd. in a haze mode at a detection voltage of 900 V. Note that with an evaluation value (bit) in microroughness, a higher value means a rougher surface.

Deterioration in a wafer surface state was greater on the wafers stored in the storage water containing an alkaline component, with results of 10 (bits) in Example 7, 0 (bit) in Example 8, 93 (bits) in Comparative Example 3 and 256 (bits) in Comparative Example 4.

Furthermore, wastewater containing a chelating agent, which is a high polymer, such as EDTA is difficult in treatment, but wastewater of used storage water containing citric acid is easy in treatment.

### (Examples 9 to 16 and Comparative Examples 5 to 7)

There were used as specimen wafers, p-type, crystal orientation of <100>, 200 mm in diameter, resistivity ranging from 16 to 24 Ω·cm, mirror polished silicon wafers.

In order to make the mirror-polished wafers to be in a state directly after polishing, an oxide film on each of the wafers was removed with a dilute HF solution, haze and particles were measured in advance and thereafter, the wafers were stored in the following various kinds of storage water 1 to 6 for 14 hours. Haze and particles were again measured on each wafer after the storage to thereby, obtain differences (Δ HAZE and Δ LPD, where LPD is an abbreviation of Light Point Defect) on each wafer before and after the storage and then, confirm deterioration in wafer surface state caused by the storage water. Haze was evaluated with a haze made of LS-6500 (made by Hitachi Electronics Engineering Co. Ltd.; at a detection voltage of 900 V). With an evaluation value (bits) of haze (also referred to as microroughness), a larger value shows a rougher wafer surface. Particles equal to or larger than 0.10 µm were counted by the LS-6500. A storage pit (water bath) in use was made from quartz. Dissolved oxygen in pure water was almost 5 mg/L (25°C).

The storage water 1 to 5 used in the above experiments was as follows:

### Storage water 1 (Examples 9 to 11)

Storage water 1 was prepared by adding polyoxyethylenealkyl ether into pure water so as to be 0.01 wt % (Example 9), 0.05 wt % (Example 10), and 0.1 wt % (Example 11), respectively, (at this time, pH = 5.9).

### Storage water 2 (Examples 12 to 14)

Storage water 2 was prepared by adding polyoxyethylene polyoxypropylene ether into pure water so as to be 0.01 wt % (Example 12), 0.1 wt % (Example 13), and 0.2 wt % (Example 14), respectively, (at this time, pH = 5.9).

### Storage water 3 (Comparative Example 5)

Storage water 3 is constituted of pure water only (at this time, pH = 6.1).

### Storage water 4 (Comparative Example 6)

Storage water 4 was prepared by adding aqueous ammonia into pure water so as to be 0.005 wt % (at this time, pH = 9.6).

### Storage water 5 (Comparative Example 7)

Storage water 5 was prepared by adding HCl into pure water so as to be 0.005 wt % (at this time, pH = 2.9).

### (Examples 15 and 16)

Then a step of coating a wafer surface with a surfactant and a step of storing a wafer were independently carried out.

As a surfactant with which a wafer surface was coated, polyoxyethylenealkyl ether was used so as to be at 10 wt % (Example 15) and 30wt % (Example 16). Each wafer was immersed into a vessel filled with a surfactant solution directly after polishing, and then stored in storage water constituted of pure water. A storage time for each wafer in the storage water was 12 hours.

Table 4 shows differences in haze and particles on each of wafers before and after the storage (Δ HAZE and Δ LPD) using storage water for Examples 9 to 16 and Comparative Examples 5 to 7.

**Table 4**

| | Concentration (wt %) | ΔLPD | ΔHAZE |
|---|---|---|---|
| Example 9 | 0.01 | 18 | 1 |
| Example 10 | 0.05 | 16 | 0 |
| Example 11 | 0.10 | 15 | 1 |
| Example 12 | 0.01 | 15 | 0 |
| Example 13 | 0.10 | 15 | 0 |
| Example 14 | 0.20 | 19 | 1 |
| Example 15 | 10.0 | 13 | 1 |
| Example 16 | 30.0 | 14 | 0 |
| Comparative Example 5 | _ | 9999 | 110 |
| Comparative Example 6 | _ | 9999 | 256 |
| Comparative Example 7 | _ | 53 | 10 |

As apparently seen from Table 4, in the second aspect of storage water using a surfactant of the present invention, it has been confirmed that both deterioration in haze and attachment of particles can be prevented.

### Capability of Exploitation in Industry:

As described above, according to the first aspect of storage water of the present invention, attachment of fine particles including metals on wafer surface decreases and etching on the wafer surface caused by a alkaline component in a polishing agent is prevented and as a result, a great effect is achieved of preventing deterioration in a wafer quality, particularly deterioration in gate oxide integrity after cleaning. According to the second aspect of storage water of the present invention, by use of a surfactant as one component of storage water for storing a silicon wafer, deterioration in haze and attachment of particles can be prevented and particularly, an effect of preventing deterioration in haze on a wafer surface to an almost perfect degree is achieved in pure water having much of dissolved oxygen or in the storage water of the acid side.

## Claims

1. Storage water for a storing silicon wafer in water comprising:
pure water; and
an organic acid having a chelating effect,
which storage water is in the state ranging from being weakly acid to neutral.

2. The storage water according to claim 1, wherein the organic acid having a chelating effect is a water-soluble organic acid having ten or less carbon atoms and two or more carboxyl groups.

3. The storage water according to claim 2, wherein the organic acid is citric acid.

4. The storage water according to any of claims 1 to 3, which further comprises a surfactant.

5. The storage water according to any of claims 1 to 4, which has a pH value ranging from 3 to 7.

6. The storage water according to any of claims 1 to 5, which contains the organic acid in the concentration range of from 0.0001 to 0.01 %.

7. Storage water for storing a silicon wafer comprising: pure water; and a nonionic surfactant.

8. The storage water according to claim 7, wherein the nonionic surfactant is polyoxyalkylenealkyl ether and/or polyoxyethylene polyoxypropyene ether.

9. The storage water according to claim 7 or 8, wherein a concentration of the nonionic surfactant is equal to or more than 0.01 %.

10. The storage water according to any of claims 7 to 9, a pH value of which is equal to or less than 7.

11. The storage water according to any of claims 7 to 10, wherein a dissolved oxygen concentration is equal to or higher than 3 mg/L.

12. The storage water according to any of claims 7 to 11, consisting of the nonionic surfactant and the pure water only.

13. A method for storing a silicon wafer in water, wherein the wafer is stored in the storage water according to any of claims 1 to 12.

14. The method for storing a silicon wafer comprising the steps of: coating a surface of the silicon wafer with a nonionic surfactant; and storing the silicon wafer coated with the surfactant in pure water.

15. The method for storing a silicon wafer according to claim 14, wherein in storing the silicon wafer coated with the surfactant in the pure water, the pure water contains an organic acid having a chelating effect.

16. The method for storing a silicon wafer according to any of claims 13 to 15, wherein the silicon wafer is stored after an etching step and/or a polishing step.
